# EUROPEAN PATENT APPLICATION

(11) **EP 1 968 132 A2**
(43) Date of publication of application: **10.09.2008**
(21) Application number: 08101731.1
(22) Date of filing: 19.02.2008
(51) Int. Cl.: H01L 51/52

(54) **Organic Light-Emitting Display Device**

(30) Priority: 07.03.2007 KR 20070022594
(71) Applicant: Samsung SDI Co., Ltd., Suwon-si, Gyeonggi-do (KR)
(72) Inventor: Lee, Joon-Gu, Gyeonggi-do (KR); Song, Young-Woo, Gyeonggi-do (KR); Hwang, Kyu-Hwan, Gyeonggi-do (KR); Oh, Jong-Seok, Gyeonggi-do (KR); Ha, Jae-Heung, Gyeonggi-do (KR); Park, Chul-Woo, Gyeonggi-do (KR); Lee, Jong-Hyuk, Gyeonggi-do (KR)
(74) Representative: Perkins, Dawn Elizabeth

(57) **Abstract**

Provided is an organic light-emitting display apparatus that can display a color image without a color filter and prevent a reduction in contrast due to the reflection of external light. The organic light-emitting display apparatus includes: a substrate (1); an organic light-emitting device (3) disposed on the substrate and emitting white light; a sealing member (5) disposed on the organic light-emitting device; a dichroic layer (22) comprising ellipsoidal shaped metal particles which are imprinted on one surface of the substrate and allowing light of a predetermined wavelength band to be transmitted therethrough according to an aspect ratio of the metal particles; and a 1/4 wavelength layer (21) deposited on one of surfaces formed by the substrate and the dichroic layer, and disposed farther away from a direction in which an external light is incident than the dichroic layer, wherein an image is displayed towards the substrate.

## Description

The present invention relates to an organic light-emitting display device, and more particularly, to an organic light-emitting display device capable of displaying a color image without a color filter and preventing a reduction in contrast due to the reflection of external light.

Display devices have recently replaced thin-type flat display devices. Organic or inorganic light-emitting display devices, which are self-emissive devices, are considered to be the next-generation of flat display devices owing to their wide viewing angles, excellent contrast, and fast response speed, in comparison to other flat display devices. Organic light-emitting display devices in which emission layers are formed of an organic material have excellent characteristics in terms of brightness, driving voltage, and response speed compared to inorganic light-emitting display devices, and can display color images.

A method of displaying color images involves emitting white light, transmitting the white light through a color filter, and separating the white light into the three primary colors of light. However, a color filter is required for this method.

Meanwhile, organic light-emitting display devices have reduced contrast due to light reflected therefrom when images are viewed in bright environments (e.g., in sunlight). One way of improving contrast in organic light-emitting display devices is to use a circular polarizer.

A circular polarizer used in conventional organic light-emitting display devices is in the form of a film, and is formed by attaching a linear polarization film and a λ/4 retardation film to an image display surface using an adhesive. However, it is difficult to form such a film-type circular polarizer to be thin since it includes films and an adhesive layer.

Accordingly, a thin, organic light-emitting display device that can display color images and improve contrast without a circular polarizer film and a color filter is required.

The present invention provides an organic light-emitting display device that can be formed to be thin, have better contrast, and display color images.

According to an aspect of the present invention, there is provided an organic light-emitting display apparatus comprising: a substrate; an organic light-emitting device disposed on the substrate and emitting white light; a sealing member disposed on the organic light-emitting device; a dichroic layer comprising ellipsoidal shaped metal particles which are imprinted on one surface of the substrate and allowing light of a predetermined wavelength band to be transmitted therethrough according to an aspect ratio of the metal particles; and a 1/4 wavelength layer deposited on one of surfaces formed by the substrate and the dichroic layer, and disposed farther away from a direction in which an external light is incident than the dichroic layer, wherein an image is displayed towards the substrate.

The substrate may be formed of glass.

The dichroic layer may be formed on the substrate, the 1/4 wavelength layer may be deposited on the dichroic layer, and the organic light-emitting device may be disposed on the 1 /4 wavelength layer.

The 1/4 wavelength layer may be deposited on a surface of the substrate, the organic light-emitting device may be disposed on the 1/4 wavelength layer, and the dichroic layer may be formed on a surface of the substrate opposite to that on which the 1/4 wavelength layer is deposited.

The dichroic layer may comprise three areas through which red, blue, and green light is transmitted, respectively.

According to another aspect of the present invention, there is provided an organic light-emitting display apparatus comprising: a substrate; an organic light-emitting device disposed on the substrate and emitting white light; a sealing member disposed on the organic light-emitting device; a dichroic layer comprising ellipsoidal shaped metal particles which are imprinted on one surface of the sealing member and absorb light of a predetermined wavelength band according to an aspect ratio of the metal particles; and a 1/4 wavelength layer deposited on one of surfaces formed by the organic light-emitting device, the sealing member, and the dichroic layer, and disposed farther away from a direction in which an external light is incident than the dichroic layer, wherein an image is displayed towards the sealing member.

The sealing member may be formed of glass.

The sealing member may be a transparent substrate, the dichroic layer may be formed on a surface of the sealing member facing the organic light-emitting device, and the 1/4 wavelength layer may be deposited on a surface of the dichroic layer facing the organic light-emitting device.

The sealing member may be a transparent substrate, the 1/4 wavelength layer may be deposited on a surface of the sealing member facing the organic light-emitting device, and the dichroic layer may be formed on a surface of the sealing member opposite to that on which the 1/4 wavelength layer is deposited.

The organic light-emitting display apparatus may further comprise a protective layer disposed on the organic light-emitting device, wherein the sealing member is a transparent substrate, the dichroic layer is formed on a surface of the sealing member facing the organic light-emitting device, and the 1 /4 wavelength layer is deposited between the organic light-emitting device and the protective layer.

The organic light-emitting display apparatus may further comprise a protective layer disposed on the organic light-emitting device, wherein the sealing member is a transparent substrate, the 1/4 wavelength layer is disposed between the organic light-emitting device and the protective layer, and the dichroic layer is formed on a surface of the sealing member opposite to that on which the 1/4 wavelength layer is deposited.

The protective layer may comprise at least one of an organic insulating material and an inorganic insulating material.

The dichroic layer may comprise three areas through which red, blue, and green light is transmitted, respectively.

According to another aspect of the present invention, there is provided an organic light-emitting display apparatus comprising: a substrate; a thin film transistor disposed on the substrate; an organic light-emitting device disposed on the substrate, emitting white light, and electrically connected to the thin film transistor; a sealing member disposed on the organic light-emitting device; a dichroic layer comprising ellipsoidal shaped metal particles which are imprited on one surface of the substrate and allowing light of a predetermined wavelength band to be transmitted therethrough according to an aspect ratio of the metal particles; and a 1 /4 wavelength layer deposited on one of surfaces formed by the substrate and the dichroic layer, and disposed farther away from a direction in which an external light is incident than the dichroic layer, wherein an image is displayed towards the substrate.

The dichroic layer may comprise three areas through which red, blue, and green light is transmitted, respectively.

The substrate may be formed of glass.

The dichroic layer may be formed on the substrate, the 1/4 wavelength layer may be deposited on the dichroic layer, and the thin film transistor and the organic light-emitting device may be disposed on the 1/4 wavelength layer.

The 1/4 wavelength layer may be deposited on a surface of the substrate, the thin film transistor and the organic light-emitting device may be disposed on the 1/4 wavelength layer, and the dichroic layer may be formed on a surface of the substrate opposite to that on which the 1/4 wavelength layer is deposited.

According to another aspect of the present invention, there is provided an organic light-emitting display device comprising: a substrate; a thin film transistor disposed on the substrate; an organic light-emitting device disposed on the substrate, emitting white light, and electrically connected to the thin film transistor; a sealing member disposed on the organic light-emitting device; a dichroic layer formed of ellipsoidal shaped metal particles which are imprinted on one surface of the sealing member and allowing light of a predetermined wavelength band according to an aspect ratio of the metal particles; and a 1/4 wavelength layer deposited on one of surfaces formed by the organic light-emitting device, the sealing member, and the dichroic layer, and disposed farther away from a direction in which an external light is incident than the dichroic layer, wherein an image is displayed of the sealing member.

The dichroic layer may comprise three areas through which red, blue, and green light is transmitted, respectively.

The sealing member may be formed of glass.

The sealing member may be a transparent substrate, the dichroic layer may be formed on a surface of the sealing member facing the organic light-emitting device, and the 1/4 wavelength layer may be deposited on a surface of the dichroic layer facing the organic light-emitting device.

The sealing member may be a transparent substrate, the 1/4 wavelength layer may be deposited on a surface of the sealing member facing the organic light-emitting device, and the dichroic layer may be formed on a surface of the sealing member opposite to that on which the 1/4 wavelength layer is deposited.

The organic light-emitting display apparatus may further comprise a protective layer disposed on the organic light-emitting device, wherein the sealing member is a transparent substrate, the dichroic layer is formed on a surface of the sealing member facing the organic light-emitting device, and the 1 /4 wavelength layer is disposed between the organic light-emitting device and the protective layer.

The organic light-emitting display apparatus may further comprise a protective layer disposed on the organic light-emitting device, wherein the sealing member is a transparent substrate, the 1/4 wavelength layer is disposed between the organic light-emitting device and the protective layer, and the dichroic layer is formed on a surface of the sealing member opposite to that on which the 1/4 wavelength layer is deposited.

The protective layer may comprise at least one of an organic insulating material and an inorganic insulating material.

The above and other features and advantages of the present invention will become more apparent by describing in detail exemplary embodiments thereof with reference to the attached drawings in which:
FIG. 1 is a schematic sectional view illustrating a rear emission type organic light-emitting display device according to an embodiment of the present invention;
FIGS. 2 and 3 are graphs schematically illustrating the characteristics of a dichroic layer of the rear emission type organic light-emitting display device of FIG. 1, according to an embodiment of the present invention;
FIG. 4 is a sectional view illustrating a 1/4 wavelength layer of the rear emission type organic light-emitting display device of FIG. 1, according to an embodiment of the present invention;
FIG. 5 is a schematic sectional view illustrating a rear emission type organic light-emitting display device according to another embodiment of the present invention;
FIGS. 6 through 9 are schematic sectional views illustrating front emission type organic light-emitting display devices according to embodiments of the present invention;
FIG. 10 is a sectional view illustrating a rear emission type active matrix (AM) organic light-emitting display device according to another embodiment of the present invention; and
FIG. 11 is a sectional view illustrating a front emission type AM organic light-emitting display device according to an embodiment of the present invention.

The present invention will now be described more fully with reference to the accompanying drawings, in which exemplary embodiments of the invention are shown.

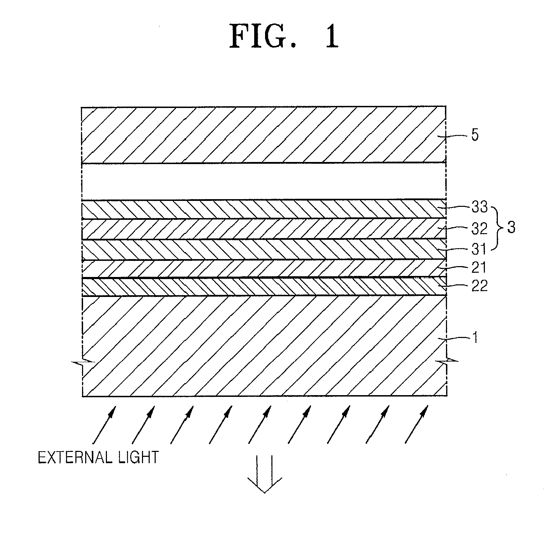

FIG. 1 is a schematic sectional view illustrating a rear emission type organic light-emitting display device according to an embodiment of the present invention. Referring to FIG. 1, the organic light-emitting display device according to the current embodiment of the present invention includes a substrate 1 formed of a transparent material, a dichroic layer 22, a 1/4 wavelength layer 21, an organic light-emitting device 3, and a sealing member 5 that are sequentially stacked on the substrate 1.

The substrate 1 may be a transparent glass substrate formed of mainly Si02. Although not shown, a buffer layer may be further disposed on the substrate 1 in order to increase substrate smoothness and prevent the infiltration of impurities. The buffer layer may be formed of at least one of Si02 and SiNx, or the like.

The dichroic layer 22 is formed on the substrate 1, and the 1/4 wavelength layer 21 is formed on the dichroic layer 22. The organic light-emitting device 3 is disposed on the 1/4 wavelength layer 21. The dichroic layer 22 and the 1/4 wavelength layer 21 are stacked in such a way that the dichroic layer 22 is disposed to be close to the incidence side of external light, and the 1/4 wavelength layer 21 is disposed on a surface of the dichroic layer 22 opposite to that on which external light is incident. Any light-transmissive layer may be interposed between the dichroic layer 22 and the 1/4 wavelength layer 21.

The dichroic layer 22 may be formed of ellipsoidal-shaped metal particles. The metal particles can be Ag, Au, W, Cr or the like. For example, an ion exchange technique of a metal mixture NaN03/AgN03can be used to produce Ag particles on the substrate 1. If the substrate 1 on which a metal layer is formed is heated at a temperature of about 650 °C and stretched, the Ag particles are imprinted on a surface of the substrate 1 in a direction in which the glass substrate 1 is stretched.
A laser beam or an E-beam is irradiated onto the metal particles. A ratio of lengths of major and minor axes of the ellipsoidal-shaped metal particles, i.e., an aspect ratio, can vary according to the amount of the irradiated energy. The characteristics of the dichroic layer 22 formed of the ellipsoidal-shaped metal particles are polarization of the incident light and absorption of light of a predetermined wavelength band.

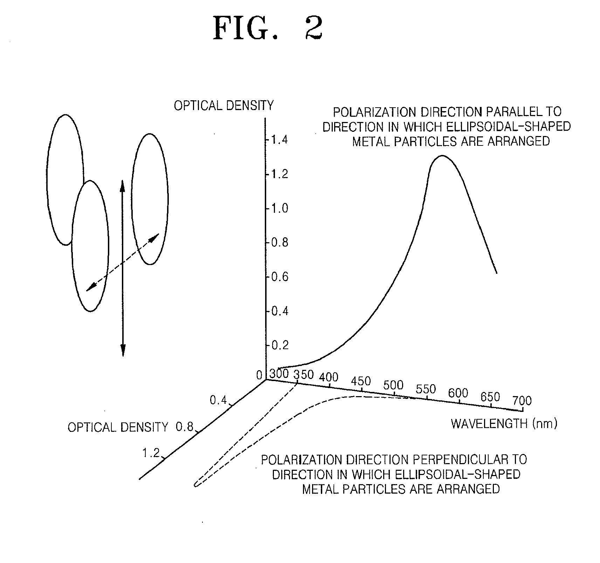

FIG. 2 is a graph illustrating the polarization characteristic of the dichroic layer 22 formed of the Ag particles illustrated in FIG. 1, according to an embodiment of the present invention. Referring to FIG. 2, optical density is high in a visible light area of the dichroic layer 22 in a polarization direction (a vertical axis) parallel to a direction in which the ellipsoidal-shaped Ag particles are arranged, whereas the optical density is approximately 0 in the visible light area of the dichroic layer 22 in a polarization direction (a horizontal axis) perpendicular to the direction in which the ellipsoidal-shaped Ag particles are arranged. That is, the dichroic layer 22 has the polarization characteristics that the direction parallel to the direction in which the ellipsoidal-shaped Ag particles are arranged is an optical transmission axis, and the polarization direction perpendicular to the direction in which the ellipsoidal-shaped Ag particles are arranged is an optical absorption axis.

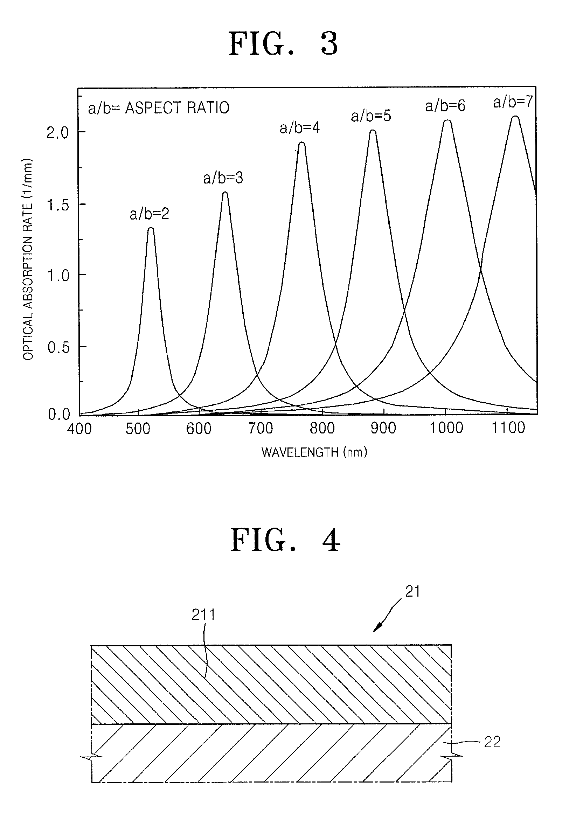

FIG. 3 is a graph illustrating the variation of an optical absorption rate of the Ag particles with respect to wavelength according to an aspect ratio a/b of the Ag particles, i.e., a ratio of lengths of major b and minor a axes of the ellipsoidal-shaped metal particles. Referring to FIG. 3, when the aspect ratio a/b of the Ag particles is 2, the optical absorption rate is the highest at a wavelength of about 540 nm close to a green band. When the aspect ratio a/b of the Ag particles is 3, the optical absorption rate is the highest at a wavelength of about 650 nm close to a red band. In other words, the amount of energy of a laser beam or an E-beam irradiated onto the Ag particles is appropriately adjusted to vary the aspect ratio a/b of the Ag particles, so that white light emitted from an emission layer 32 of the organic light-emitting device 3 can converted into light of a desired color.

The dichroic layer 22 can include three areas through which red, blue, and green light, respectively, is transmitted. Therefore, according to an embodiment of the present invention, a color image of a white organic light-emitting device can be formed using the dichroic layer 22 formed on the substrate 1 without a color filter, thereby dramatically reducing the thickness of the white organic light-emitting device.

The 1/4 wavelength layer 21 is formed on the dichroic layer 22 having the color image display and the polarization characteristics as illustrated in FIG. 4.

Referring to FIG. 4, the 1/4 wavelength layer 21 can be formed by coating a liquid crystal film or by oblique deposition using an inorganic material. In the latter, micro-columns 211 extend in an oblique direction on the surface of the 1/4 wavelength layer 21, which is disclosed in Korean Patent Application No. 2006-0136887. The micro-columns 211 are aligned along the direction of the crystal growth.

When depositing an inorganic material, the inorganic material grows in a cylindrical shape. Thus, in oblique deposition, these cylinders are tilted at a predetermined angle with respect to the horizontal direction of FIG. 4. As a result, the 1/4 wavelength layer 21 has birefringence characteristics. The inorganic material that can be used to form the 1/4 wavelength layer 21 may be selected from various materials such as Ti02 and TaOx. When the 1/4 wavelength layer 21 is formed of CaO or BaO, it can have moisture absorption properties, in addition to the birefringence characteristics.

According to an embodiment of the present invention, the dichroic layer 22 and the 1/4 wavelength layer 21 constitute a circular polarizer, thereby minimizing the reflection of external light.

Among external light incident on the bottom side of the substrate 1, light components corresponding to an absorption axis of the dichroic layer 22 are absorbed in the dichroic layer 22, and light components corresponding to a transmission axis of the dichroic layer 22 are transmitted through the dichroic layer 22. The light components corresponding to the transmission axis of the dichroic layer 22 are converted to circularly polarized light components rotating in one direction while they pass through the 1/4 wavelength layer 21, and are then reflected from a second electrode layer 33 of the organic light-emitting device 3. When they are reflected from the second electrode layer 33, the circularly polarized light components rotating in one direction are converted to circularly polarized light components rotating in another direction. While they again pass through the 1/4 wavelength layer 21, the circularly polarized light components rotating in the other direction are converted to linearly polarized light components which are perpendicular to the transmission axis of the dichroic layer 22. Thus, the linearly polarized light components are absorbed into the dichroic layer 22 along the absorption axis of the dichroic layer 22, so that they are not emitted from the bottom side of the substrate 1. Therefore, the reflection of external light is minimized, thereby resulting in better contrast.

In addition, since the dichroic layer 22 and the 1/4 wavelength layer 21 are formed on the substrate 1 with no adhesive interposed therebetween, the thickness of the rear emission type organic light-emitting display apparatus according to the current embodiment of the present invention can be reduced compared to conventional organic light-emitting display devices. Moreover, since there is no adhesive layer, an image from the emission layer 32 does not pass through an adhesive layer, like in conventional organic light-emitting display devices, thereby resulting in better brightness.

The organic light-emitting device 3 is disposed on the 1/4 wavelength layer 21. The organic light-emitting device 3 includes a first electrode layer 31 and the second electrode layer 33 which face each other, and the emission layer 32 interposed therebetween.

The first electrode layer 31 may be formed of a transparent and conductive material, e.g., indium tin oxide (ITO), indium zinc oxide (IZO), In2O3, or ZnO. The first electrode layer 31 may be patterned using photolithography.

In passive matrix (PM) organic light-emitting display devices, patterns of the first electrode layer 31 may be in the form of striped lines which are spaced apart from each other at predetermined intervals. In active matrix (AM) organic light-emitting display devices, patterns of the first electrode layer 31 may be formed to correspond to pixels. Moreover, in AM organic light-emitting display devices, a thin film transistor (TFT) layer including at least one TFT is further disposed on the substrate 1 below the first electrode layer 31, and the first electrode layer 31 is electrically connected to the TFT layer.

The first electrode layer 31 structured as a transparent electrode can serve as an anode when it is connected to an external terminal (not shown).

The second electrode layer 33 is disposed above the first electrode layer 31. The second electrode layer 33 may be a reflective electrode and may be formed of at least one of aluminum, silver, and calcium. The second electrode layer 33 can serve as a cathode when it is connected to a second electrode terminal (not shown).

In a PM organic light-emitting display apparatus, the second electrode layer 33 may be in the form of striped lines perpendicular to the patterns of the first electrode layer 31. In an AM organic light-emitting display apparatus, the second electrode layer 33 may be formed to correspond to each pixel. In the AM organic light-emitting display apparatus, the second electrode layer 33 may be formed over the entire surface of an active area in which images are displayed. A detailed description thereof will be provided later.

The polarity of the first electrode layer 31 may be opposite to that of the second electrode layer 33.

The emission layer 32 interposed between the first electrode layer 31 and the second electrode layer 33 emits white light in response to the electrical driving of the first electrode layer 31 and the second electrode layer 33. The white light may have a good color rendering index (CRI) (> 75), and be close to a coordinate of (0.33, 0.33) in a Commission Internationale de I'Eclairage (CIE) diagram. However, the present invention is not limited thereto.

The emission layer 32 may be formed of a low molecular weight organic material or a polymer organic material. When the emission layer 32 is a low molecular weight organic layer formed of a low molecular weight organic material, a hole transport layer and a hole injection layer are stacked on a surface of an organic emission layer (EML) facing the first electrode layer 31, and an electron transport layer and an electron injection layer are stacked on a surface of the organic emission layer facing the second electrode layer 33. Of course, in addition to the hole injection layer, the hole transport layer, the electron transport layer, and the electron injection layer, various layers may be formed when needed.

When the emission layer 32 is a polymer organic layer formed of a polymer organic material, only a hole transport layer (HTL) may be formed on a surface of an organic emission layer facing the first electrode layer 31. The polymer hole transport layer may be formed on the first electrode layer 31 by inkjet printing or spin-coating using poly-(2,4)-ethylene-dihydroxy thiophene (PEDOT), polyaniline (PANI), or the like.

In order for the emission layer 32 to emit white light, a wave conversion technique such as down conversion in which phosphor is excited with blue light or violet light, various colors emitted from the phosphor are mixed, and a wide band of a wavelength spectrum is formed, a color mixing technique in which two primary colors (blue and orange) or three primary colors (red, green, and blue) are mixed and white light is formed, or the like can be used. However, the present invention is not limited thereto. A variety of materials and techniques can be applied to emit the white light.

The sealing member 5 such as glass, a thin film member, a metal cap, etc. for sealing the organic light-emitting device 3 is disposed on the organic light-emitting device 3 in order to protect the organic light-emitting device 3 from external moisture or oxygen. Referring again to FIG. 1, the sealing member 5 is spaced apart from the organic light-emitting device 3 by a predetermined interval. However, the sealing member 5 illustrated in FIG. 1 is only one embodiment of the present invention,. As described above, organic and inorganic thin films are not spaced apart from the organic light-emitting device 3 but can be stacked on the organic light-emitting device 3.

According to an embodiment of the present invention, the white light emitted from the emission layer 32 of the organic light-emitting device 3 passes through the dichroic layer 22, thereby being changed into light of a predetermined color, and the reflection of external light incident on the bottom side of the substrate 1 is minimized by the dichroic layer 22 and the 1/4 wavelength layer 21, thereby preventing a reduction in contrast. Also, the dichroic layer 22 and the 1/4 wavelength layer 21 are formed on the substrate 1 without a color filter and a circular polarization film, thereby reducing the thickness of the organic light-emitting display apparatus according to the current embodiment of the present invention.

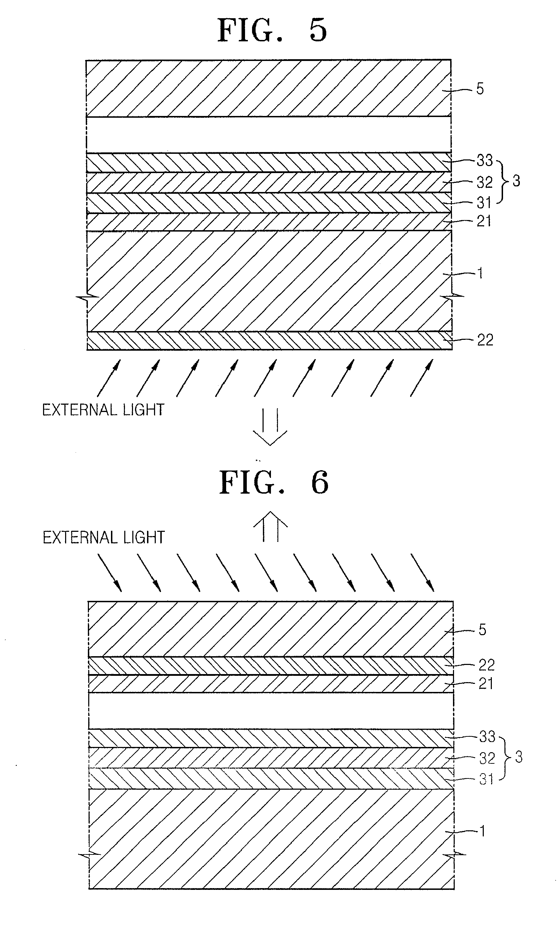

FIG. 5 is a schematic sectional view illustrating a rear emission type organic light-emitting display apparatus according to anther embodiment of the present invention. Referring to FIG. 5, a dichroic layer 22 is formed on the surface of a substrate 1 on which external light is incident, and a 1/4 wavelength layer 21 is formed on the other surface of the substrate 1. An organic light-emitting device 3 is disposed on the 1 /4 wavelength layer 21. These constitutional devices are as described above.

According to the current embodiment of the present invention, as described above, external light incident on the substrate 1 is converted to linearly polarized light which is parallel to the transmission axis of the dichroic layer 22 while it passes through the dichroic layer 22. The linearly polarized light is transmitted through the substrate 1 and then converted to circularly polarized light rotating in one direction while it passes through the 1/4 wavelength layer 21. The circularly polarized light rotating in one direction is reflected from a second electrode layer 33 of the organic light-emitting device 3 and then converted to circularly polarized light rotating in another direction. While it again passes through the 1/4 wavelength layer 21, the circularly polarized light rotating in the other direction is converted to linearly polarized light which is perpendicular to the transmission axis of the dichroic layer 22. The linearly polarized light cannot pass through the dichroic layer 22, and thus, the external light incident on the substrate 1 cannot be reflected from the substrate 1.

White light emitted from an emission layer 32 of the organic light-emitting device 3 is transmitted through the dichroic layer 22 that selectively absorbs light of a specific wavelength band according to an aspect ratio and is converted into a predetermined color, thereby forming a color image without a color filter.

FIG. 6 is a schematic sectional view illustrating a front emission type organic light-emitting display apparatus according to an embodiment of the present invention. Referring to FIG. 6, an organic light-emitting device 3 is disposed on a substrate 1. A sealing member 5 for sealing the organic light-emitting device 3 is disposed on the organic light-emitting device 3. A dichroic layer 22 and a 1/4 wavelength layer 21 are sequentially formed on a surface of the sealing member 5 facing the organic light-emitting device 3.

The substrate 1 may be a transparent glass substrate as described above, but does not necessarily have to be transparent since light emitted from an emission layer 32 is transmitted toward the sealing member 5. The substrate 1 may be formed of a plastic material or a metal material, in addition to glass. When the substrate 1 is formed of a metal, an insulating film may be disposed on a surface of the metal. Although not shown, a buffer layer may be further disposed on the substrate 1 in order to increase substrate smoothness and prevent the infiltration of impurities. The buffer layer may be formed of at least one of Si02 and SiNx, or the like.

A first electrode layer 31 of the organic light-emitting device 3 may be formed on the substrate 1. The material for forming the organic light-emitting device 3 may have a high work function, for example, a material such as ITO, IZO, ZnO, or In2O3. In this case, the first electrode layer 31 serves as an anode. If the first electrode layer 31 is used as a cathode, the first electrode layer 31 may be formed of Mg, Al, Pt, Pd, Au, Ni, Nd, Ir, Cr, or a compound thereof so that the first electrode layer 31 can also serve as a reflective layer. Hereinafter, the present invention will be described in terms of the use of the first electrode layer 31 as an anode.

A second electrode layer 33 of the organic light-emitting device 3 may be formed as a transmissive electrode. Thus, the second electrode layer 33 may be formed as a thin translucent film using a metal with a low work function, e.g., Li, Ca, LiF/Ca, LiF/Al, Al, Mg, or Ag. Of course, when a transparent and conductive structure formed of ITO, IZO, ZnO, or In2O3 is formed on such a metal translucent film, a high resistance problem due to the thinness of the translucent film can be overcome.

The emission layer 32 is interposed between the first electrode layer 31 and the second electrode layer 33 and is as described above.

A sealing member 5 for sealing the organic light-emitting device 3 is further disposed on the organic light-emitting device 3 in order to protect the organic light-emitting device 3 from external moisture or oxygen. In the current embodiment of the present invention, the sealing member 5 is formed of transparent glass, a dichroic layer 22 is formed on a surface of the sealing member 5, and a 1/4 wavelength layer 21 is formed on the surface of the dichroic layer 22 facing the organic light-emitting device 3. Therefore, white light emitted from the emission layer 32 is transmitted through the dichroic layer 22 and forms a predetermined color image. Also, external light incident on an upper surface of the sealing member 5 passes through the sealing member 5 which is transparent and then passes through the dichroic layer 22 and the 1/4 wavelength layer 21 in sequence. The incident light, after being reflected from each of the first and second electrode layers 31 and 33 of the organic light-emitting device 3 cannot pass through the 1/4 wavelength layer 21, thereby preventing a reduction in contrast. The principle is as described above, and thus, a detailed description thereof will be omitted.

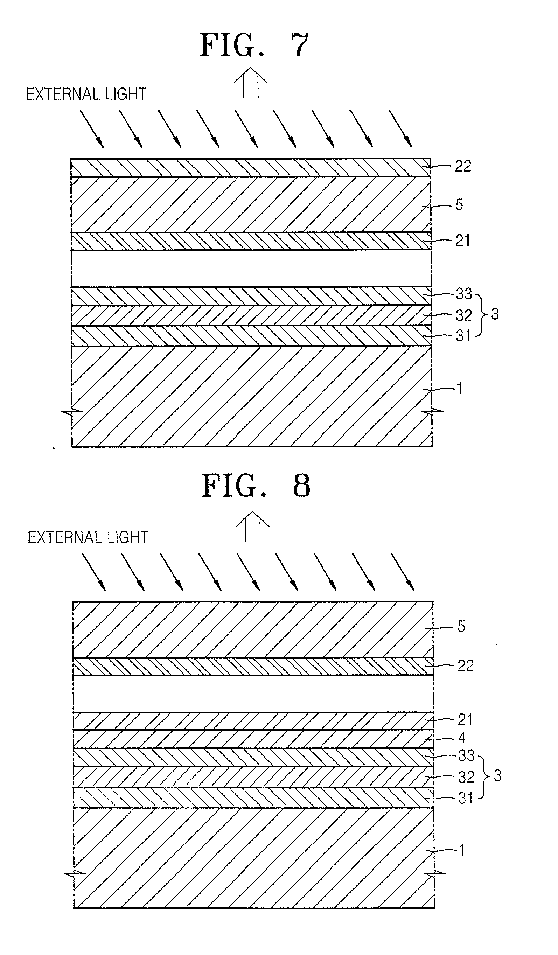

FIG. 7 is a schematic sectional view illustrating a front emission type organic light-emitting display apparatus according to another embodiment of the present invention. Referring to FIG. 7, a dichroic layer 22 is formed on an outside surface of a sealing member 5, i.e., a surface on which external light is incident, and a 1/4 wavelength layer 21 is formed on an inside surface of the sealing member 5, i.e., the surface facing an organic light-emitting device 3. As described above, external light incident on the front emission type organic light-emitting display apparatus, indicated by the arrows, is converted to linearly polarized light which is parallel to the transmission axis of the dichroic layer 22 while it passes through the dichroic layer 22. The linearly polarized light is converted to circularly polarized light rotating in one direction while it passes through the 1/4 wavelength layer 21. The circularly polarized light rotating in one direction is reflected from the organic light-emitting device 3 and then converted to circularly polarized light rotating in another direction. While it again passes through the 1/4 wavelength layer 21, the circularly polarized light rotating in the other direction is converted to linearly polarized light which is perpendicular to the transmission axis of the dichroic layer 22. The linearly polarized light cannot pass through the dichroic layer 22, and thus, the externally incident light cannot be reflected from the front emission type organic light-emitting display apparatus according to the current embodiment of the present invention. White light emitted from the emission layer 32 is transmitted through the dichroic layer 22 and forms a predetermined color image.

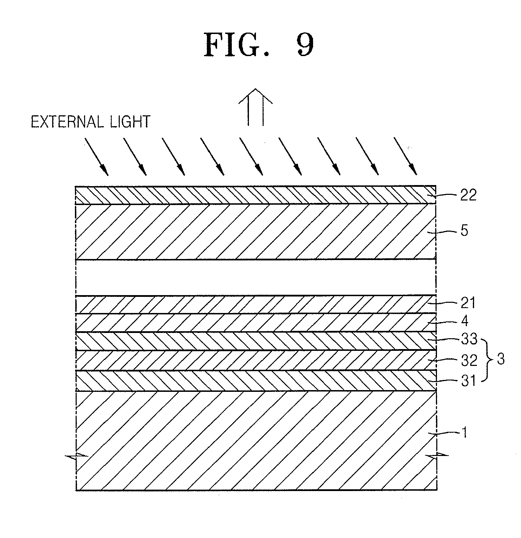

FIGS. 8 and 9 are schematic sectional views illustrating front emission type organic light-emitting display apparatuses where a protective layer 4 is further disposed on an organic light-emitting device 3, and a 1/4 wavelength layer 21 is formed on the protective layer 4 according to other embodiments of the present invention.

In the front emission type organic light-emitting display apparatus of FIG. 8, a dichroic layer 22 is formed on an inside surface of a sealing member 5, while in the front emission type organic light-emitting display apparatus of FIG. 9, a dichroic layer 22 is formed on an outside surface of a sealing member 5. However, both embodiments are identical to each other in that a 1/4 wavelength layer 21 is formed on a protective layer 4 that is disposed on an organic light-emitting device 3.

The protective layer 4 serves to prevent damage to a second electrode layer 33 of the organic light-emitting device 3 during the formation of the 1/4 wavelength layer 21, and may be formed of a transparent inorganic or organic material.

Examples of the inorganic material that may be used to form the protective layer 4 include metal oxide, metal nitride, metal carbide, metal oxynitride, and compounds thereof. The metal oxide may be silicon oxide, aluminum oxide, titanium oxide, indium oxide, tin oxide, indium tin oxide, or a compound thereof. The metal nitride may be aluminum nitride, silicon nitride, or a compound thereof. The metal carbide may be silicon carbide, and the metal oxynitride may be silicon oxynitride. The inorganic material may also be silicon, a ceramic derivative of silicon, or a ceramic derivative of metal. In addition, the inorganic material may be diamondlike carbon (DLC) or the like.

Examples of the organic material that may be used to form the protective layer 4 include organic polymers, inorganic polymers, organometallic polymers, and hybrid organic/inorganic polymers. An acryl resin may also be used.

As described above, white light emitted from an emission layer 32 of the organic light-emitting device 3 is transmitted through the dichroic layer 22 and forms a predetermined color image. Also, external light incident on an upper surface of the sealing member 5 cannot pass through the 1/4 wavelength layer 21, thereby preventing a reduction in contrast. The principle is as described above, and thus, a detailed description thereof will be omitted.

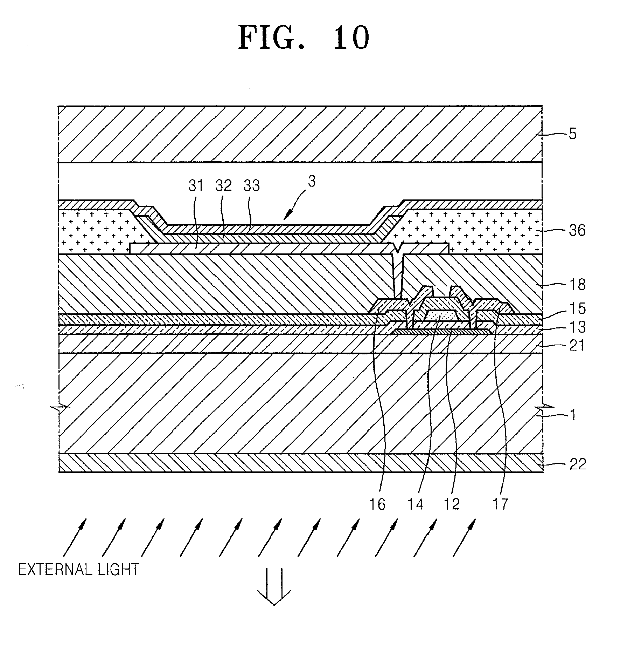

FIG. 10 is a sectional view illustrating a rear emission type active matrix (AM) organic light-emitting display device according to another embodiment of the present invention.

Referring to FIG. 10, a dichroic layer 22 is formed on a surface of a substrate 1 on which external light is incident. A thin film transistor (TFT) is disposed on a surface of the substrate 1 opposite to that on which external light is incident. Each of a plurality of pixels of the rear emission type AM organic light-emitting display apapratus includes at least one TFT. The TFT is electrically connected to an organic light-emitting device 3.

In detail, a 1/4 wavelength layer 21 is formed on the surface of the substrate 1. Although not shown, a buffer layer is disposed on an upper surface or a lower surface of the 1/4 wavelength layer 21. A semiconductor active layer 12 is formed in a predetermined pattern on the 1/4 wavelength layer 21. A gate insulating film 13 formed of Si02, SiNx, or the like is disposed on the semiconductor active layer 12, and a gate electrode 14 is disposed on a portion of the gate insulating film 13. The gate electrode 14 is connected to a gate line (not shown) applying a TFT ON/OFF signal. An inter-insulating layer 15 is disposed on the gate electrode 14, and source/drain electrodes 16 and 17 contact a source/drain region of the semiconductor active layer 12 through a contact hole.

A passivation layer 18 is formed of at least one of an organic material and an inorganic material, and is disposed on the source/drain electrodes 16 and 17. A first electrode layer 31, which is used as an anode, is disposed on the 1/4 wavelength layer 21 and is covered with a pixel-defining layer 36 formed of an insulating material. An opening is formed in the pixel-defining layer 36, and an emission layer 32 of the organic light-emitting device 3 is formed in a region defined by the opening. A second electrode layer 33 of the organic light-emitting device 3 is formed on the emission layer 32 so that all pixels are covered with the second electrode layer 33. A sealing member 5 is formed on the organic light-emitting device 3. The sealing member 5 can be formed of glass or a metal cap and has a multi-layer structure of organic/inorganic thin films.

In the above-described AM-type structure, the dichroic layer 22 and the 1/4 wavelength layer 21 can prevent the reflection of external light incident on the bottom side of the substrate 1 since the external light passes through the dichroic layer 22 and the 1/4 wavelength layer 21 in sequence. White light emitted from the emission layer 32 is transmitted through the substrate 1 and the dichroic layer 22, thereby forming a predetermined color image.

In the rear emission type AM organic light-emitting display apparatus according to the current embodiment of the present invention, provided that the dichroic layer 22 is disposed such that external light is incident thereon, and the 1/4 wavelength layer 21 is disposed to face the organic light-emitting device 3 and the 1/4 wavelength layer 21 may be formed on any surface of the substrate 1, the TFT, or the organic light-emitting device 3.

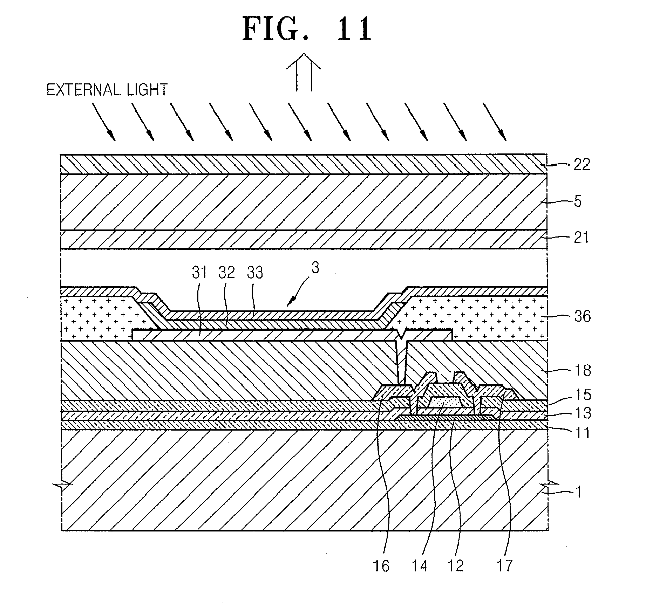

FIG. 11 is a sectional view illustrating a front emission type AM organic light-emitting display device according to an embodiment of the present invention.

Referring to FIG. 11, a TFT is disposed on a substrate 1. Each of a plurality of pixels of the front emission type AM organic light-emitting display device includes at least one TFT, and the TFT is electrically connected to an organic light-emitting device 3. The structure of the TFT is as described above with reference to FIG. 12, and thus, a detailed description thereof will be omitted.

The TFT is covered with a passivation layer 18. A first electrode layer 31, which is used as an anode, is disposed on the passivation layer 18, and is covered with a pixel-defining layer 36 formed of an insulating material. An opening is formed in the pixel-defining layer 36, and an emission layer 32 is disposed in a region defined by the opening. A second electrode layer 33 is disposed on the emission layer 32 to cover all the pixels.

In the current embodiment of the present invention, a 1/4 wavelength layer 21 is disposed on a surface of a sealing member 5 facing the organic light-emitting device 3 and a dichroic layer 22 is formed on the other surface of the sealing member 5. Therefore, the dichroic layer 22 and the 1/4 wavelength layer 21 can prevent the reflection of light incident on the top surface of the sealing member 5, and white light emitted from the emission layer 32 is transmitted through the dichroic layer 22, thereby forming a predetermined color image.

Although not shown, provided that the dichroic layer 22 is disposed such that external light is incident thereon, and the 1/4 wavelength layer 21 is disposed to face the organic light-emitting device 3, the same principle as described in the current embodiment may be applied to AM organic light-emitting display apparatuses. Although not shown, provided that a dichroic layer is disposed such that external light is incident thereon and a 1/4 wavelength layer is disposed to face an organic light-emitting device, the same principle as described in the current embodiment may be applied to PM organic light-emitting display apparatuses.

The above-described embodiments of the present invention are not limited to organic light-emitting display devices, and can also be applied to inorganic light-emitting devices, and other flat panel displays such as LCDs and electron emission devices.

According to the above-described light-emitting devices of the present invention, the following advantages can be obtained.

First, a circular polarization layer can be formed using a dichroic layer and a 1/4 wavelength layer, thereby preventing the reflection of external light, resulting in better contrast.

Second, an adhesive for attaching the circular polarization layer is not used, thereby decreasing the thickness of a display device and preventing a reduction in brightness.

Third, a white organic light-emitting device can display a color image without a color filter.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An organic light-emitting display apparatus comprising:
a transparent substrate (1, 5) through which an image is displayed;
an organic light-emitting device (3) capable of emitting white light disposed below the transparent substrate (1, 5);
a dichroic layer (22) comprising ellipsoidal shaped metal particles which are imprinted on one surface of the transparent substrate (1, 5) and allow light of a predetermined wavelength band to be transmitted therethrough according to an aspect ratio of the metal particles; and
a quarter wavelength layer (21) disposed below the dichroic layer (22) and above the organic light-emitting device (3).

2. The organic light-emitting display apparatus of claim 1, wherein the quarter wavelength layer (21) is deposited on one of the surfaces formed by the transparent substrate (1, 5) and the dichroic layer (22).

3. The organic light-emitting display apparatus of claim 2, wherein the dichroic layer (22) is formed on the lower surface of the transparent substrate (1, 5), and the quarter wavelength layer (21) is deposited on the dichroic layer (22).

4. The organic light-emitting display apparatus of claim 2, wherein the dichroic layer (22) is formed on the upper surface of the transparent substrate (1, 5) and the quarter wavelength layer (21) is deposited on the lower surface of the substrate.

5. The organic light-emitting display apparatus of claim 3 or 4, wherein the organic light-emitting device (3) is disposed on the quarter wavelength layer (21).

6. The organic light-emitting display apparatus of claim 1, further comprising a protective layer (4) disposed on an upper surface of the organic light-emitting device (3), wherein the quarter wavelength layer (21) is formed on the protective layer (4).

7. The organic light-emitting display apparatus of claim 6, wherein the dichroic layer (22) is formed on the upper surface of the transparent substrate (5).

8. The organic light-emitting display apparatus of claim 6, wherein the dichroic layer (22) is formed on the lower surface of the transparent substrate (5).

9. The organic light-emitting display apparatus of claim 6, 7 or 8, wherein the protective layer (4) comprises at least one of an organic insulating material and an inorganic insulating material.

10. The organic light-emitting display apparatus according to claim 1, further comprising:
a thin film transistor electronically connected to the organic light-emitting device (3).

11. The organic light-emitting display apparatus of claim 10, wherein the dichroic layer (22) is formed on the lower surface of the substrate (1), the quarter wavelength layer (21) is deposited on the dichroic layer (22), and the thin film transistor and the organic light-emitting device (3) are disposed on the quarter wavelength layer (21).

12. The organic light-emitting display apparatus of claim 10, wherein the quarter wavelength layer (21) is deposited on a lower surface of the substrate (1), the thin film transistor and the organic light-emitting device (13) are disposed on the quarter wavelength layer (21), and the dichroic layer (22) is formed on a top surface of the substrate (1).

13. The organic light-emitting display apparatus according to claim 10, further comprising:
a lower substrate (1);
wherein the thin film transistor is disposed on the lower substrate (1); and the organic light-emitting device (3) is disposed on the thin film transistor.

14. The organic light-emitting display apparatus of claim 13, wherein the dichroic layer (22) is formed on a lower surface of the transparent substrate (5) and the quarter wavelength layer (21) is deposited on a surface of the dichroic layer (22).

15. The organic light-emitting display apparatus of claim 13, wherein the quarter wavelength layer (21) is deposited on a lower surface of the transparent substrate (5) and the dichroic layer (22) is formed on an upper surface of the transparent substrate (5).

16. The organic light-emitting display apparatus of claim 13, further comprising a protective layer disposed on the organic light-emitting device (3),
wherein the dichroic layer (22) is formed on a lower surface of the transparent substrate (5) and the quarter wavelength layer (21) is disposed between the organic light-emitting device (3) and the protective layer.

17. The organic light-emitting display apparatus of claim 13, further comprising a protective layer disposed on the organic light-emitting device (3),
wherein the quarter wavelength layer (21) is disposed between the organic light-emitting device (3) and the protective layer, and the dichroic layer (22) is formed on an upper surface of the transparent substrate (5).

18. The organic light-emitting display apparatus of claim 16 or 17, wherein the protective layer comprises at least one of an organic insulating material and an inorganic insulating material.

19. The organic light-emitting display apparatus of any one of the preceding claims, wherein the dichroic layer (22) comprises three areas through which red, blue, and green light is transmitted, respectively.

20. The organic light-emitting display apparatus of any one of the preceding claims, wherein the transparent substrate (1, 5) is formed of glass.
